# EUROPEAN PATENT SPECIFICATION

(11) **EP 0 561 566 B1**
(45) Date of publication and mention of the grant of the patent: **28.07.1999**
(21) Application number: 93301864.0
(22) Date of filing: 11.03.1993
(51) Int. Cl.: H04R 19/04, H01G 5/16, G01L 9/00

(54) **Solid state condenser and microphone**
Festkörper-Kondensatormikrofon
Microphone à condensateur à l'état solide

(30) Priority: 18.03.1992 US 853488
(43) Date of publication of application: 22.09.1993
(73) Proprietor: KNOWLES ELECTRONICS, INC., Itasca, Illinois 60143 (US)
(72) Inventor: Loeppert, Peter V., c/o Monolithic Sensors, Inc., Rolling Meadows, Illinois 60008 (US)
(74) Representative: Allman, Peter John

(56) References cited:
- EP-A- 0 341 964
- WO-A-83/01362
- US-A- 3 772 133
- US-A- 3 991 285
- US-A- 4 651 120
- US-A- 4 993 072
- PATENT ABSTRACTS OF JAPAN vol. 14, no. 493 (E-0995) 26 October 1990 & JP-A-02 202 800 (AUDIO TECHNICA) 10 August 1990

## Description

This invention relates to solid state condensers. More particularly, it relates to miniature solid state condenser microphones useful in applications where small dimensions are desired, such as, for sensors in hearing aids.

### BACKGROUND OF THE INVENTION

A typical condenser microphone is composed of a voltage bias element, Vbias, (commonly an electret), a diaphragm/ backplate pair forming a capacitor which varies with sound pressure, and a Field Effect Transistor (FET) circuit for buffering the output signal. Miniature microphones used in hearing aids and other applications are typically electret condenser microphones. These are built with highly precision stamped metal parts, organic diaphragm films such as mylar and polyester, and highly charged electret films to bias the microphones. These microphones have certain shortcomings. Their size has been reduced to the limits of manufacturability. Lack of uniformity in the stamping and assembly processes results in a large variability in sensitivity. Furthermore, temperature and humidity effects on the organic diaphragm film and electret result in long term drift in microphone performance.

In attempts to overcome the difficulties associated with traditional miniature microphones, various workers have tried to make solid state microphones using semi-conductor techniques. Such microphones using inorganic thin films have the potential to overcome the problems associated with conventional miniature microphones. However, attempts to build such solid state microphones have not been successful in achieving the necessary sensitivity simultaneously with good manufacturability.

Conventional microphones have rectangular diaphragm/backplate pairs typically measuring several millimeters on a side with a spacing between the diaphragm and the backplate of several tens of microns. An electret bias of several hundred volts is required to bring the microphone sensitivity to the desired range. In designing a solid state microphone, for example one from silicon, it is desirable to reduce the bias voltage to the 5 to 10 volt range in order to eliminate the environmental stability problems with the electret. This voltage can conveniently be developed directly from the power supply or with conventional charge pump circuitry. Reducing the bias value requires a commensurate increase in the ratio of the change of capacitance (ΔC) to the capacitance (C) to maintain an equivalent sensitivity. One method of maintaining the sensitivity of the miniature microphone is to reduce the gap between the diaphragm and the backplate to from about 1 to about 2 microns. It is also necessary to keep the mechanical compliance of the diaphragm (deflection vs. sound pressure level) to a level at least comparable to that in conventional microphones.

In a diaphragm there are two kinds of forces which resist deflection in response to pressure. The first are plate bending forces which are proportional to the thickness of the diaphragm. These can be reduced by using a very thin film diaphragm. The second class of forces which resist deflection are membrane forces which are proportional to the tension applied to the membrane or diaphragm. In the case of a thin film diaphragm, tension is not generally put in intentionally but is a result of the fabrication technique and of mismatches in thermal expansion coefficients.

Previous workers who have prepared solid state microphones have recognized the problem of residual tension in the diaphragm. Hohm and Hess, J. Acoust. Soc. Am. 85, 476-480 (1989) used a flat silicon nitride diaphragm with large residual tension. To reduce the tension, they implanted nitrogen to relax the nitride film. However, this technique is sensitive to implant dosage and energy, and to the thermal annealing cycle. It is difficult to control uniformity of the original tension across such a diaphragm and such a process may not impart long term stability to the diaphragm.

Bergqvist and Rudolf, Transducers 91, Proceedings of the International conference on Solid-State Sensors and Actuators (IEEE, New York, 1991) pp.266-269, reduced membrane forces in a different fashion. They established a low tension diaphragm by using lightly doped single crystal silicon. While this was successful in reducing membrane tension, a parasitic capacitance was formed which cancelled the advantage of the low stress diaphragm.

It is an object of the present invention to produce a solid state microphone which can be made smaller than conventional microphones and which has a tightly controlled sensitivity. It is a further objection of the present invention to produce a solid state microphone with reduced membrane forces and with very low parasitic capacitance.

These and other objects of the invention will become apparent to those skilled in the art when the following detailed description of the invention is read in conjunction with the accompanying drawings.

According to the present invention there is provided a solid state condenser device comprising:
a fixed perforated backplate constituting a fixed electrode in a parallel plate condenser;
a diaphragm having a thickness, said diaphragm being sensitive to incident sound pressure waves and constituting a movable electrode in said parallel plate condenser; and characterised by
a plurality of clamps each defining a clamp gap to receive a portion of said diaphragm to retain said diaphragm in operative positional relationship with said backplate, wherein the width of said clamp gap is greater than said thickness of the diaphragm to thereby retain said diaphragm in position without physical attachment thereto.

The clamps are preferably disposed at the periphery of said diaphragm to receive edge portions of said diaphragm.

Preferably the clamps are substantially equally spaced around the periphery of said diaphragm.

The backplate is preferably prepared from a boron doped silicon wafer and the diaphragm is preferably a silicon nitride diaphragm.

The parallel plate condenser is preferably prepared from a single silicon wafer.

In accordance with the present invention there is provided a solid state miniature condenser of high sensitivity and good manufacturability. It overcomes the tension forces associated with reduced thickness, solid state diaphragms and its design minimizes undesirable stray capacitances encountered in some prior attempts to prepare miniature solid state condensers.

Other objects and advantages of the invention will become apparent upon reading the following detailed description and upon reference to the drawings, in which:

Figs. 1a and 1b are cross section views which illustrate the preparation of a diaphragm according to one embodiment of this invention.

Fig. 2 is a plan view of the diaphragm of Fig. 1b.

Fig. 3 is a cross section view of a backplate in accordance with an embodiment of this invention.

Fig. 4 is a plan view of the backplate of Fig. 4.

Fig. 5 is a cross section view of a condenser according to an embodiment of this invention.

Fig. 6 is a cross section view of a condenser in accordance with another embodiment of this invention.

While the invention will be described in connection with certain preferred embodiments, it is understood that it is not intended to limit the invention to those embodiments.

### DETAILED DESCRIPTION OF THE INVENTION

Solid state microphones of the prior art have employed a diaphragm whose edges were all solidly attached to the condenser. Such a solid attachment applies tension to a thin membrane during its fabrication. The present invention is based on the discovery that if the diaphragm is only loosely clamped at its edges, little tension is built up in the diaphragm. As a result, the diaphragm shows greater sensitivity in its response to sound pressure.

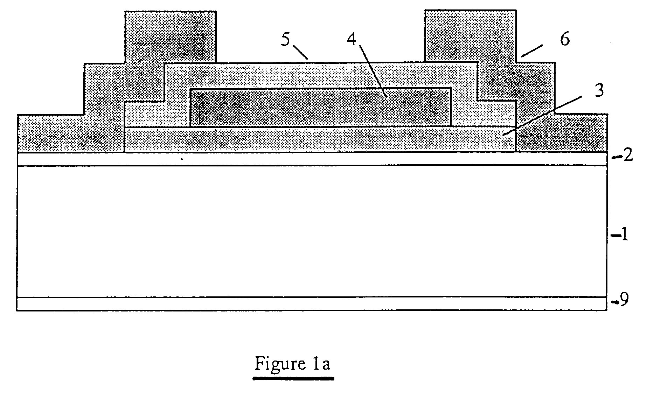

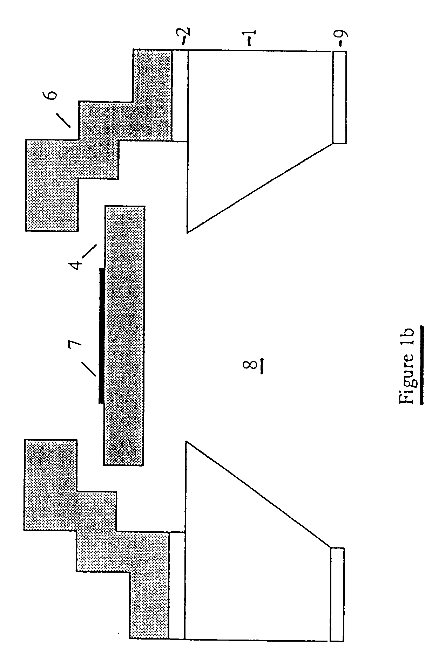

A diaphragm with low tension can be prepared by the method illustrated in Figs. 1a and 1b. A double side polished <100> orientated silicon wafer 1 is oxidized to form 1000 Å layers of oxide 2 and 9 on both sides of the wafer. Then 5000 Å layers of polycrystalline silicon (poly) are deposited on both sides of the wafer by low pressure chemical vapor deposition (LPCVD). A one micron layer of silicon nitride 4 is next deposited by plasma enhanced chemical vapor deposition (PECVD) on the front side and etched to form the diaphragm. Additional 5000 Å sacrificial layers of poly are deposited by LPCVD on top of the silicon nitride and the back side of the wafer. Both poly layers 3 and 5 on the front side of the wafer are etched just beyond the edge of nitride diaphragm 4 using a wet etch such as ethylene diamine-pyrocatechol (EDP). This etch simultaneously removes the poly layers from the back side of the wafer. A further layer of PECVD nitride of 1.5 microns thickness is deposited on the front side only and etched to form the upper clamps 6. The figures are not to scale, since the thickness of the silicon wafer 1 is very large in comparison with the other layers.

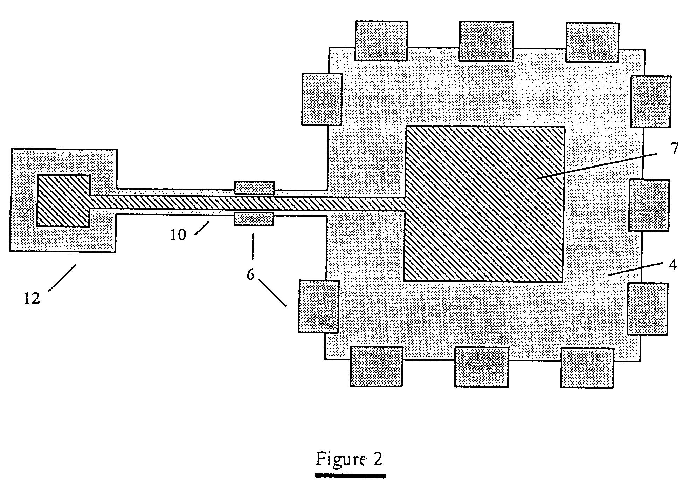

Fig. 2 shows a top view of the diaphragm with clamps 6 in place. The upper clamps are small, separate elements so that their internal stresses do not cause cracking of the clamps or the rest of the structure. These clamps can take a variety of shapes.

To complete fabrication of the diaphragm, the polycrystalline silicon layer 5 on top of the diaphragm is stripped away, and a chrome/gold metal layer 7 is deposited on the diaphragm as noted in Fig. 1b. The gold is etched off the diaphragm surface to leave only a very thin chrome layer (100-200 Å in thickness). The gold serves to connect the diaphragm with the other circuitry on the wafer. The oxide 9 on the backside of wafer is then etched to serve as a mask for the cavity etch. Soaking the wafer in an anisotropic etchant such as EDP creates cavity 8 and etches away the sacrificial polycrystalline silicon layers 3 and 5, freeing the diaphragm. A final dip in buffered HF solution removes oxide layer 2 from under the diaphragm.

A top view of the diaphragm is shown in Fig. 2. The diaphragm has a long tail member 10 off to one side which terminates in a square pad 12 that is fixed to the silicon substrate. While the diaphragm is free floating, it is restricted in movement by the silicon substrate below, the clamps above, and the long tail 10.

The metal layer 7 on the diaphragm is restricted to the central region where the diaphragm deflection is greatest. This maximizes the sensitivity of the microphone and minimizes parasitic capacitance between the diaphragm and the rest of the structure. Because the diaphragm is insulated from the silicon substrate, parasitic capacitance is further reduced by application of a guard voltage, derived from the output of an FET circuit, to the substrate.

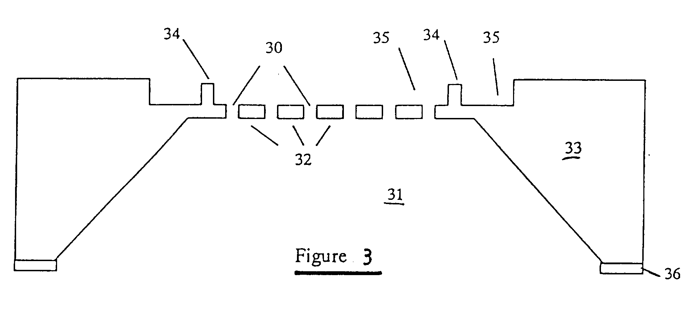

The design of a backplate used in the practice of this invention is best seen by reference to Fig 3. This shows in cross section a backplate 32 prepared by etching a silicon wafer. Backplate 32 has a number of perforations 30 to minimize stiffness due to air trapped between the diaphragm and the backplate. The backplate is prepared from a silicon chip which has been heavily doped with boron. This puts the backplate under tension, enhances conductivity, and serves as an etch stop to create the needed geometry. Bergqvist, mentioned above, pointed out the need for a highly perforated backplate. However, he incorrectly identified the need for a low stress in the backplate by using lightly doped single crystal silicon. Actually, a stiff backplate is preferred since it gives the highest possible relative motion between the diaphragm and the backplate.

The fabrication of the backplate begins with a double polished, <100> oriented silicon wafer 33 on which a nitride layer is deposited and etched to mask the shallow gap 35. The shallow gap is etched about 2 microns deep into the silicon with an isotropic etchant. The remaining nitride is removed and a new layer is deposited and etched to leave tiny islands positioned over the locations where the holes 30 are desired. A heavy boron dose is diffused into the front surface to form a p⁺ etch stop approximately 4 microns deep. The nitride 36 on the back of the wafer resulting from the second deposition, is etched to serve as a mask for the cavity etch. Soaking the wafer in an anisotropic etchant such as EDP forms the cavity 31, leaving the perforated backplate 32.

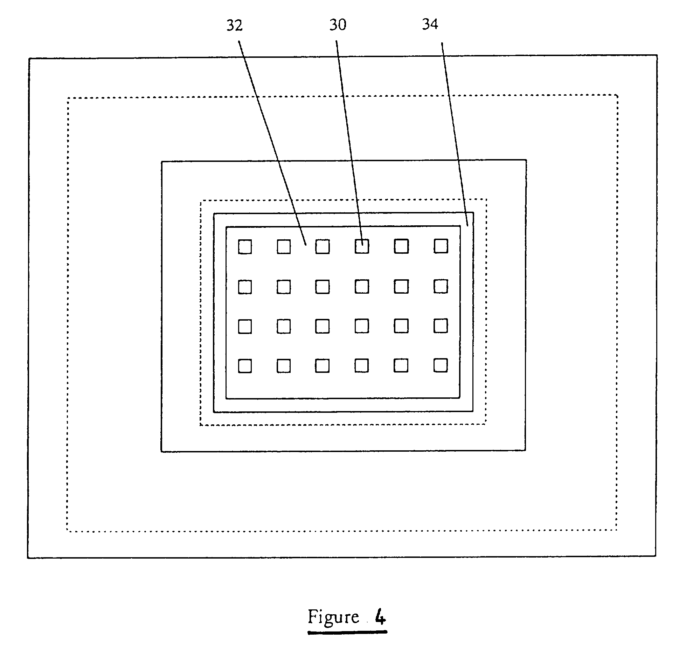

Fig. 4 shows a plan view of the backplate. In this figure a comparatively small number of holes 30 are illustrated. However, in carrying out the invention, it is frequently convenient to prepare a backplate with many more perforations.

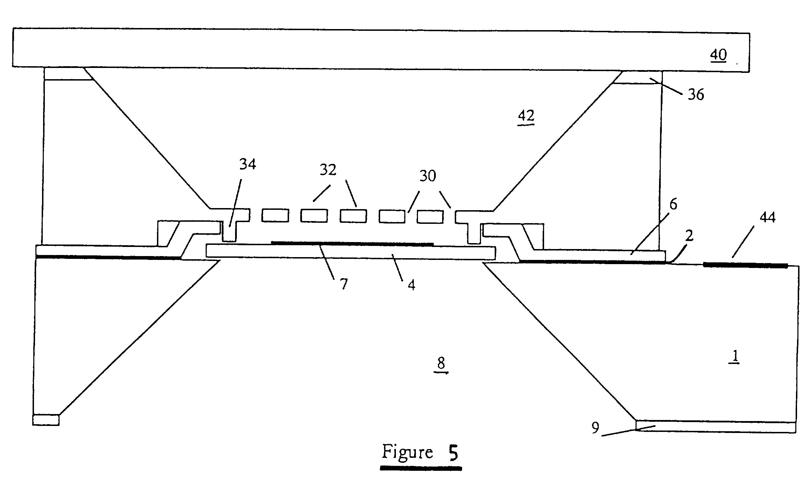

In accordance with this invention, the diaphragm and backplate are bonded together using one of the common techniques such as eutectic soldering, electrostatic bonding, or silicon fusion bonding. A bonded pair is shown in cross section in Fig. 5. In order to complete the unit for use in a microphone, the combination of diaphragm and backplate is mounted on a support 40 which serves to form, with the backplate, a closed backchamber 42. The FET circuitry 44 as well as a bias source is easily integrated on one of the silicon pieces to form a complete microphone element.

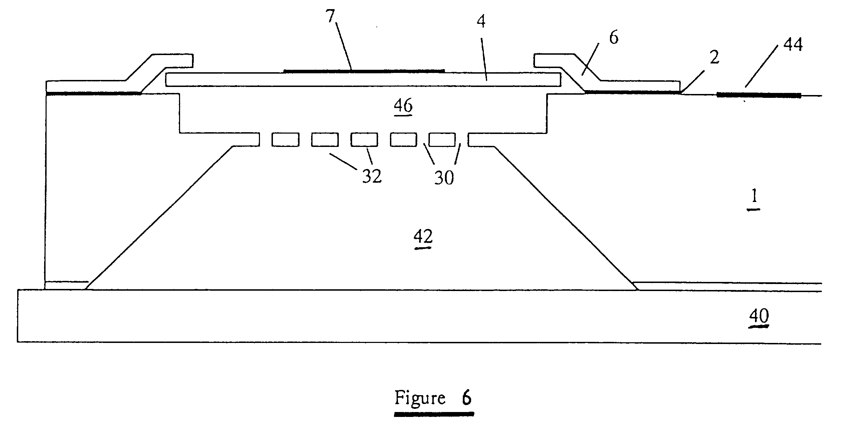

In accordance with a further aspect of the invention, the diaphragm and backplate may be formed on a single silicon wafer. This arrangement is illustrated in Fig. 6. In this embodiment of the invention, backplate 32 is defined first using the boron doping process illustrated in Fig. 3 without first forming the shallow gap. After the boron doping, phosphorous is diffused into region 46 to counter dope the boron. The front surface of the wafer remains relatively planar and the p⁺ etch stop is now buried below the surface. The diaphragm 4 and clamps 6 are next fashioned on the silicon wafer 1 using the same general procedure illustrated in Figs. 1a and 1b. When the wafer is soaked in EDP to form cavity 42, the sacrificial layers are removed to free the diaphragm and gap 46 is created. The silicon wafer containing backplate 32 is attached to base 40 to give a closed backchamber 42. FET circuitry 44 and a voltage bias source are integrated on the silicon piece to form a complete microphone element.

In carrying out this invention, it is necessary to avoid acoustical leaks around the diaphragm between the sound source and backchamber 42. Such acoustical leaks are prevented in the device in Fig. 6 because the edges of diaphragm 4 contact silicon wafer 1 as it moves towards the backplate by electrostatic attraction created by the bias voltage. In the device illustrated in Fig. 5, an acoustical leak is prevented by means of ring 34 in the backplate member which engages diaphragm 4 as it moves toward the backplate under the same electrostatic attraction. However, these devices permit low frequency airflow from the backchamber to compensate for any static pressure differences between the backchamber and the environment.

The present invention has been described with respect to certain embodiments and conditions, which are not meant to limit the invention. Those skilled in the art will understand the variations from the embodiments and conditions described herein may be made without departing from the invention as set forth in the appended claims.

## Claims

1. A solid state condenser device comprising:
a fixed perforated backplate (32) constituting a fixed electrode in a parallel plate condenser;
a diaphragm (4) having a thickness, said diaphragm (4) being sensitive to incident sound pressure waves and constituting a movable electrode in said parallel plate condenser; and characterised by
a plurality of clamps (6) each defining a clamp gap to receive a portion of said diaphragm (4) to retain said diaphragm (4) in operative positional relationship with said backplate, wherein the width of said clamp gap is greater than said thickness of the diaphragm (4) to thereby retain said diaphragm (4) in position without physical attachment thereto.

2. The device of claim 1, wherein said clamps (6) are disposed at the periphery of said diaphragm (4) to receive edge portions of said diaphragm (4).

3. The device of any preceding claim, wherein said plurality of clamps (6) are substantially equally spaced around the periphery of said diaphragm (4).

4. The device of any preceding claim wherein the backplate (32) is prepared from a boron doped silicon wafer.

5. The device of any preceding claim, wherein the diaphragm (4) is a silicon nitride diaphragm.

6. The device of any preceding claim, wherein the parallel plate condenser is prepared from a single silicon wafer.

## Patentansprüche

1. Halbleiter-Kondensatorbauelement, das folgendes umfaßt:
eine feste perforierte Gegenplatte (32), die eine feste Elektrode in einem Parallelplattenkondensator bildet;
eine Membrane (4), die eine Dicke aufweist, wobei die Membrane (4) für auffallende Schalldruckwellen empfindlich ist und eine bewegbare Elektrode in dem Parallelplattenkondensator bildet; und das gekennzeichnet ist durch
eine Mehrzahl von Klemmen (6), die jeweils einen Klemmenzwischenraum definieren, um einen Abschnitt der Membrane (4) aufzunehmen, um die Membrane (4) in einer betriebsbereiten Lagebeziehung zur Gegenplatte zu halten, und bei denen die Breite des Klemmenzwischenraums größer ist als die Dicke der Membrane (4), um dadurch die Membrane (4) ohne physische Befestigung daran in ihrer Stellung zu halten.

2. Bauelement nach Anspruch 1, bei dem die Klemmen (6) an der Peripherie der Membrane (4) angeordnet sind, um Randabschnitte der Membrane (4) aufzunehmen.

3. Bauelement nach einem der vorhergehenden Ansprüche, bei dem die Mehrzahl von Klemmen (6) im wesentlichen abstandsgleich um die Peripherie der Membrane (4) herum liegen.

4. Bauelement nach einem der vorhergehenden Ansprüche, bei dem die Gegenplatte (32) aus einer mit Bor dotierten Kristallscheibe gefertigt ist.

5. Bauelement nach einem der vorhergehenden Ansprüche, bei dem die Membrane (4) eine Siliziumnitridmembrane ist.

6. Bauelement nach einem der vorhergehenden Ansprüche, bei dem der Parallelplattenkondensator aus einer einzigen Kristallscheibe gefertigt ist.

## Revendications

1. Dispositif de condensation à l'état solide comprenant:
une plaque dorsale perforée fixe (32) constituant une électrode fixe dans un dispositif de condensation à plaques parallèles;
un diaphragme (4) possédant une épaisseur, ledit diaphragme (4) étant sensible à des ondes incidentes de pression acoustique et constituant une électrode mobile dans ledit dispositif de condensation à plaques parallèles, et caractérisé par
plusieurs pinces (6) définissant chacune un espace de pincement destiné à recevoir une portion dudit diaphragme (4) afin de retenir ledit diaphragme (4) en relation de position de travail avec ladite plaque dorsale, la largeur dudit espace de pincement étant supérieure à ladite épaisseur du diaphragme (4) pour ainsi retenir ledit diaphragme (4) en position sans y être fixé par voie physique.

2. Dispositif selon la revendication 1, dans lequel lesdites pinces (6) sont disposées à la périphérie dudit diaphragme (4) pour recevoir des portions marginales dudit diaphragme (4).

3. Dispositif selon l'une quelconque des revendications précédentes, dans lequel lesdites plusieurs pinces (6) sont essentiellement équidistantes autour de la périphérie du diaphragme (4).

4. Dispositif selon l'une quelconque des revendications précédentes, dans lequel la plaque dorsale (32) est préparée à partir d'une plaquette de silicium dopée au bore.

5. Dispositif selon l'une quelconque des revendications précédentes, dans lequel le diaphragme (4) est un diaphragme de nitrure de silicium.

6. Dispositif selon l'une quelconque des revendications précédentes, dans lequel le dispositif de condensation à plaques parallèles est préparé à partir d'une plaquette unique de silicium.
